Europäisches Patentamt

European Patent Office

Office européen des brevets

(11) Veröffentlichungsnummer: **0 321 961 B1**

## (12) EUROPÄISCHE PATENTSCHRIFT

(45) Veröffentlichungstag der Patentschrift: **12.08.92**

(51) Int. Cl.⁵: **H05K 13/00**

(21) Anmeldenummer: **88121416.7**

(22) Anmeldetag: **21.12.88**

(54) **Verfahren zum Gurten von Abstimmdioden mit fliessendem Übergang der Kapazitätsgleichlaufgruppen.**

(30) Priorität: **23.12.87 DE 3743955**

(43) Veröffentlichungstag der Anmeldung:
**28.06.89 Patentblatt 89/26**

(45) Bekanntmachung des Hinweises auf die
Patenterteilung:
**12.08.92 Patentblatt 92/33**

(84) Benannte Vertragsstaaten:
**AT DE FR GB IT**

(56) Entgegenhaltungen:
**EP-A- 0 137 045**
**GB-A- 2 177 060**

(73) Patentinhaber: **SIEMENS AKTIENGESELL-SCHAFT**
**Wittelsbacherplatz 2**
**W-8000 München 2(DE)**

(72) Erfinder: **Gabler, Franz, Dipl.-Ing. (FH)**
**Nelkenweg 6**
**W-8411 Lappersdorf(DE)**

## Beschreibung

Die Erfindung bezieht sich auf ein Verfahren zum Gurten von Abstimmdioden, insbesondere in SMD-Bauform, bei dem die Dioden eines bestimmten Typs durch Messung ihrer Kennlinienwerte in Abhängigkeit von vorgegebenen Spannungswerten in Kapazitätsgleichlaufgruppen mit einer Kapazitätsabweichung $\frac{\Delta C}{C} \leq 3$ % sortiert und als solche unterteilt ohne Gruppenabstand in einem Gurt befestigt werden.

Ein solches Verfahren ist aus der EP-A-0 137 045 bekannt.

Kapazitäts- bzw. Abstimmdioden aus Halbleitermaterial, vorzugsweise aus Silizium, finden bekanntlich beispielsweise in UHF- und VHF-Tunern von Fernsehempfängern Anwendung. Pro Tuner werden je nach Schaltungskonzept mehrere Abstimmdioden einer Type eingebaut. Um die Empfangseigenschaften zu gewährleisten, müssen diese Dioden über den gesamten Abstimmbereich im Gleichlauf auf

$$\frac{C_{max} - C_{min}}{C_{min}} \quad ,$$

d.h. $\frac{\Delta C}{C} \leq 3$ % sortiert sein.

In der Praxis fallen pro Typ ca. 15.000 verschiedene Gleichlaufgruppen an. Theoretisch würde die Gleichlaufgruppenanzahl sogar mehr als 1 Million betragen. Zum automatischen Bestücken von Platinen für derartige Geräte werden diese Dioden im Gurt verpackt.

Derartige Verfahren zum Gurten von Kapazitäts- bzw. Abstimmdioden sind bekannt. Die Abstimmdioden liegen dabei in geläufigen Gehäusebauformen mit Drahtanschlüssen und neuerdings auch in der sogenannten SMD(Surface Mounted Device)-Bauform vor.

Bei diesen bekannten Verfahren werden die seriengefertigten Dioden eines bestimmten Typs durch Messung ihrer Kennlinienwerte in Abhängigkeit von vorgegebenen, empirisch ermittelten Spannugnswerten bzw. Meßpunkten, in Kapazitätsgleichlaufgruppen mit einer maximal zulässigen Kapazitätsabweichung $\frac{\Delta C}{C} \leq 3$ % sortiert und als solche dann unterteilt, und zwar durch Leerstellen getrennt, an einem Gurt befestigt. Die Dioden werden polaritätsorientiert gegurtet. Die Trennung bzw. Kennzeichnung der - unter Datenblattbedingungen nicht mischbaren Paarungsgruppen gleichlaufsortierter Kapazitäts- bzw. Abstimmdioden - erfolgt dabei bekanntlich durch sechs Leerstellen. Um die Gleichlaufeigenschaften zu erhalten, muß der Anwender die Verpackungseinheit seriell abarbeiten.

Ein nach den bekannten Verfahren bestückter Verpackungsgurt weist jedoch den erheblichen Nachteil auf, daß sich auf dem Gurt Gleichlaufgruppen mit unterschiedlicher Stückzahl und vor allem in willkürlicher Reihenfolge befinden. Das hat zur Folge, daß jeder Gleichlaufgruppenwechsel ein manuelles, d.h. zeitaufwendiges Eingreifen beim Anwender erfordert. Der Bestückungsautomat erkennt zwar das Gruppenende und stoppt. Dann müssen eventuell vorhandene Restdioden einer Gruppe von Hand entfernt werden. Auf jeden Fall muß der Gurt aber manuell zum Beginn der nächsten Gruppe vorgeführt werden.

Der Erfindung liegt die Aufgabe zugrunde, ein Gurtungsverfahren für Abstimmdioden zu schaffen, bei dem diese Nachteile vermieden sind, das bei der Gurtung von Abstimmdioden einen fließenden Übergang der Gleichlaufgruppen gewährleistet, und das damit dem Anwender ein serielles, mit minimalem Zeitaufwand verbundenes Abarbeiten der Abstimmdioden vom Gurt ermöglicht.

Diese Aufgabe wird bei einem Verfahren der eingangs genannten Art erfindungsgemäß dadurch gelöst, daß zum seriellen Abarbeiten der Abstimmdioden vom Gurt die sortierten Kapazitätsgleichlaufgruppen in einem Zwischenschritt auf minimalen Gleichlaufgruppenabstand aussortiert werden, derart, daß die maximale Kapazitätsabweichung zweier benachbarter Gleichlaufgruppen den zweifachen vorgegebenen Wert nicht überschreitet und die Gleichlaufgruppen in dieser Reihenfolge ohne Gruppenabstand im Gurt befestigt werden oder daß die Kapazitätsabweichung einer vorgegebenen Anzahl von auf minimalen Gleichlaufgruppenabstand aussortierten, im Gurt befestigten Dioden einer jeden Gleichlaufgruppe nachgemessen wird und zum Einhalten der obengenannten Bedingungen für die maximale Kapazitätsabweichung zweier benachbarter Gleichlaufgruppen jeweils am Ende einer Gleichlaufgruppe die diese Abweichung gegebenenfalls überschreitende Anzahl von Dioden aus dem Gurt entfernt wird.

Vorzugsweise ist dabei vorgesehen, daß die vorgegebene Kapazitätsabweichung $\frac{\Delta C}{C}$ von jeweils acht aufeinanderfolgenden Abstimmdioden mit gleitendem Gruppenverlauf nachgemessen wird ,und daß Abstimmdioden mit außerhalb der vorgegebenen Kapazitätsabweichung liegenden Meßwerten aus dem Gurt entfernt werden.

Die mit der Erfindung erzielten Vorteile bestehen insbesondere darin, daß durch das erfindungsgemäße Verfahren der Gleichlaufgruppensortierung mit anschließend gleitender $\frac{\Delta C}{C}$ -Überprüfung es ermöglicht wird, Gleichlaufgruppen so zu kombinieren, daß ein fließender Übergang zwischen den einzelnen Gruppen geschaffen wird. Eine Trennung durch Leerstellen und die damit verbundenen Probleme mit Reststückzahlen pro Gruppe, beispielsweise bei einem Bedarf von sechs Stück pro Tuner, ein vorhandener Rest von fünf Stück, treten dabei nicht auf.

Mit dem erfindungsgemäßen Gurtungsverfahren wird eine wesentliche und für die Praxis akzeptable Annäherung an den Idealzustand erreicht. Der Idealfall wäre der, daß eine Verpackungseinheit einer Gleichlaufgruppe entspräche. Das würde bedeuten, daß, wenn man die Stückzahl der zu gurtenden Abstimmdioden in Abhängigkeit von deren Kapazität betrachtet, alle Dioden, d.h. sämtliche Gleichlaufgruppen mit gleichen Kennlinien innerhalb einer vertretbaren Toleranzgrenze $\frac{\Delta C}{C} \leq 3\%$ liegen müßten. Der gegenwärtige Zustand ist der, daß die Gleichlaufgruppen mit Werten innerhalb dieser vorgeschriebenen Toleranzgrenze aussortiert werden, daß diese einzelnen Gruppen jedoch untereinander praktisch unvermeidlich in ihren Kennlinienwerten schwanken. Mit der Erfindung wird nun erreicht, daß dem Gurt nicht beliebige Gleichlaufgruppen zugeführt werden, sondern daß diese nach Zufall aufgebauten Gruppen sortiert und in entsprechender Reihenfolge in minimalen $\frac{\Delta C}{C}$ - Abstand zueinander gebracht gezielt dem Gurt zugeführt werden. Die Übergänge von Gruppe zu Gruppe sind dabei zwar noch abgestuft; der Übergang ist jedoch fließend, so daß die vorgeschriebene maximale Kapazitätsabweichung nicht überschritten werden kann. Durch ein abschließendes Nachmessen der $\frac{\Delta C}{C}$ -Streubreite von vorzugsweise jeweils acht Dioden ist die Einhaltung dieser Toleranzgrenze gewährleistet.

Das erfindungsgemäße Gurtungsverfahren ist auch bei Gurtformen anwendbar, bei denen mehrere in Bandlaufrichtung parallel zueinander angeordnete Gleichlaufgruppen zur parallelen Abarbeitung durch Multiplace-Anlagen vorgesehen sind.

**Patentansprüche**

1. Verfahren zum Gurten von Abstimmdioden, insbesondere in SMD-Bauform, bei dem die Dioden eines bestimmten Typs durch Messung ihrer Kennlinienwerte in Abhängigkeit von vorgegebenen Spannungswerten in Kapazitätsgleichlaufgruppen mit einer Kapazitätsabweichung $\frac{\Delta C}{C} \leq 3\%$ sortiert und als solche unterteilt ohne Gruppenabstand in einem Gurt befestigt werden, **dadurch gekennzeichnet, daß** zum seriellen Abarbeiten der Abstimmdioden vom Gurt die sortierten Kapazitätsgleichlaufgruppen in einem Zwischenschritt auf minimalen Gleichlaufgruppenabstand aussortiert werden, derart, daß die maximale Kapazitätsabweichung zweier benachbarter Gleichlaufgruppen den zweifachen vorgegebenen Wert nicht überschreitet und die Gleichlaufgruppen in dieser Reihenfolge im Gurt befestigt werden oder daß die Kapazitätsabweichung einer vorgegebenen Anzahl von auf minimalen Gleichlaufgruppenabstand aussortierten, im Gurt befestigten Dioden einer jeden Gleichlaufgruppe nachgemessen wird und zum Einhalten der obengenannten Bedingungen für die maximale Kapazitätsabweichung zweier benachbarter Gleichlaufgruppen jeweils am Ende einer Gleichlaufgruppe die diese Abweichung gegebenenfalls überschreitende Anzahl von Dioden aus dem Gurt entfernt wird.

2. Verfahren nach Anspruch 1, **dadurch gekennzeichnet, daß** die vorgegebene Kapaziätsabweichung $\frac{\Delta C}{C}$ von jeweils acht aufeinanderfolgenden Abstimmdioden mit gleitendem Gruppenverlauf nachgemessen wird, und daß Abstimmdioden mit außerhalb der vorgegebenen Kapazitätsabweichung liegenden Meßwerten aus dem Gurt entfernt werden.

**Claims**

1. Process for taping tuning diodes, in particular of the SMD design, in which the diodes of a specific type are sorted by measuring their characteristic line values as a function of predetermined voltage values into capacitance synchronisation groups with a capacitance deviation $\frac{\Delta C}{C} \leq 3\%$ and, subdivided as such, are attached to a tape without group spacing, characterised in that, in order to serially process the tuning diodes from the tape, the sorted capacitance synchronisation groups are sorted out in an intermediate step into minimum synchronisation group spacing in such a way that the maximum capacitance deviation of two adjacent synchronisation groups does not exceed twice the predetermined value and the synchronisation groups are attached to the tape in this sequence, or that the capacitance deviation of a predetermined number of diodes, which are sorted out into minimum synchronisation group spacing and attached to the tape, of each synchronisation group is subsequently measured and, in order to maintain the abovementioned condition for the maximum capacitance deviation of two adjacent synchronisation groups, the number of diodes possibly exceeding this deviation is removed from the tape in each case at the end of a synchronisation group.

2. Process according to Claim 1, characterised in that the predetermined capacitance deviation $\frac{\Delta C}{C}$ of eight successive tuning diodes in each case is subsequently measured with sliding group response, and that tuning diodes with measured values lying outside the predetermined capacitance deviation are removed from the tape.

**Revendications**

1. Procédé pour la mise en place sur bandes de diodes d'accord, notamment sous la forme SMD, selon lequel on trie les diodes déterminées au moyen d'une mesure des valeurs de leurs caractéristiques en fonction de valeurs prédéterminées de la tension dans des groupes de synchronisation de capacité possédant un écart de capacité $\frac{\Delta C}{C} \leq 3$ % et on les fixe séparément en tant que telles sur une bande, sans écart entre groupes, caractérisé par le fait que pour le détachement en série des diodes d'accord à partir de la bande, on extrait les groupes de synchronisation de capacité triés, lors d'une étape intermédiaire, sur la base d'un écart minimum entre les groupes de synchronisation de telle sorte que l'écart maximum de capacité de deux groupes de synchronisation voisins ne dépasse pas le double de la valeur prédéterminée, et on fixe les groupes de synchronisation dans cette succession sur la bande ou qu'on remesure l'écart de capacité pour un nombre prédéterminé de diodes, qui sont extraites sur la base d'une distance minimale des groupes de synchronisation et sont fixées sur la bande, de chaque groupe de synchronisation et, pour respecter la condition indiquée précédemment concernant l'écart maximum des capacités de deux groupes de synchronisation voisins, on élimine de la bande, respectivement à l'extrémité d'un groupe de synchronisation, le nombre de diodes, qui dépasse éventuellement cet écart.

2. Procédé suivant la revendication 1, caractérisé par le fait que l'on remesure l'écart de capacité prédéterminé $\frac{\Delta C}{C}$ de respectivement huit diodes d'accord successives, présentant une allure de groupe glissante, et qu'on élimine de la bande des diodes d'accord possédant des valeurs de mesure situées à l'extérieur de l'écart de capacité prédéterminé.